# EUROPEAN PATENT APPLICATION

(11) **EP 4 685 669 A1**
(43) Date of publication of application: **28.01.2026**
(21) Application number: 24774175.4
(22) Date of filing: 20.03.2024
(51) Int. Cl.: G06F 16/909, G06F 16/904

(54) **METHOD AND APPARATUS FOR GENERATING ENVIRONMENT MODEL, DISPLAY METHOD AND APPARATUS, DEVICE AND STORAGE MEDIUM**

(30) Priority: 20.03.2023 CN 202310270464
(71) Applicant: Lumi United Technology Co., Ltd., Shenzhen, Guangdong 518000 (CN)
(72) Inventor: MENG, Yujing, Shenzhen, Guangdong 518000 (CN); YE, Feng, Shenzhen, Guangdong 518000 (CN)
(74) Representative: Metida
(86) International application number: PCT/CN2024/082813
(87) International publication number: WO 2024/193610

(57) **Abstract**

Provided by the present application are a method and apparatus for generating an environment model, a display method and apparatus, an electronic device and a computer-readable storage medium. The method for generating an environment model comprises : displaying a spatial layout diagram corresponding to a target scene, the spatial layout diagram being generated on the basis of the relationship between the trajectory of a first target object in the target scene and each space in the target scene; identifying each second target object deployed in the target scene, and obtaining the position of each identified second target object in the target scene; and according to the position of each second target object in the target scene and the spatial layout diagram corresponding to the target scene, generating an environment model of the target scene, the environment model being used for describing the state of at least one of the first target object and a second target object in the target scene.

## Description

The present disclosure claims priority of Chinese patent application No. 2023102704643 with an invention title "METHOD FOR GENERATING AN ENVIRONMENTAL MODEL, METHOD FOR DISPLAYING AN ENVIRONMENTAL MODEL, APPARATUS, DEVICE, AND STORAGE MEDIUM" filed on March 20, 2023, the entire content of which is incorporated herein by reference.

### TECHNICAL FIELD

The present disclosure relates to the technical field of Internet of Things (IoT) technology, and in particular, the present disclosure relates to a method for generating an environmental model, method for displaying an environmental model, apparatus, device, and storage medium.

### BACKGROUND

With the development in the field of Internet of Things technology, smart devices may be deployed in various scenes. For example, the scene may be a smart home scene, to provide users with device control services for the smart devices in the scene. This allows thereby enabling users to experience a more comfortable living, learning, or working environment.

Consequently, people are increasingly concerned with how to better monitor the smart devices in the scene so that the environment may be adjusted in a timely manner. In existing device monitoring solutions, users may not intuitively monitor the smart devices in the smart home scene. For instance, multiple air conditioners are deployed in the living room, and the temperature in the upper left area of the living room is too high. Because users are unaware of the positions of the individual air conditioners in the living room, they are unable to determine which air conditioner should be controlled in order to adjust the temperature in the upper left area of the living room. This affects the effectiveness of the device control service.

From the above, it may be seen that the related art still lacks a solution for intuitively monitoring the smart devices in the scene. Consequently, the effectiveness of the device control service is compromised.

### SUMMARY OF THE DISCLOSURE

The present disclosure provides a method for generating an environmental model, a method for displaying an environmental model, an apparatus, an electronic device, and a storage medium.

Based on one aspect of the present disclosure, a method for generating an environmental model, performed by an electronic device, including: displaying a spatial layout diagram corresponding to a target scene; wherein the spatial layout diagram is generated based on a relationship between a trajectory of a first target object in the target scene and each space in the target scene; identifying second target objects deployed in the target scene and determining positions of second target objects in the target scene; generating an environmental model of the target scene, based on the positions of the second target objects in the target scene and the spatial layout diagram corresponding to the target scene; wherein the environmental model is configured to describe at least one state of the first target object and of each second target object in the target scene.

Based on another aspect of the present disclosure, a method for displaying an environmental model includes: displaying an environmental model corresponding to a target scene; the environmental model including at least one state of first target objects and of the second target objects in the target scene; wherein the environmental model is generated based on a spatial layout diagram of the target scene and positions of the second target objects in the target scene; wherein the spatial layout diagram is generated based on a relationship between a trajectory of each first target object in the target scene and each space in the target scene; when a change in at least one state of the first target objects and the second target objects is recognized, displaying at least one of an updated first target object and of an updated second target object in the environmental model.

Based on another aspect of the present disclosure, an apparatus for generating an environmental model includes: a layout diagram display module, configured to display a spatial layout diagram corresponding to a target scene; wherein the spatial layout diagram is generated based on a relationship between a trajectory of a first target object in the target scene and each space in the target scene; an object identification module, configured to identify second target objects deployed in the target scene and determine positions of second target objects in the target scene; a model generation module, configured to generate an environmental model of the target scene, based on the positions of the second target objects in the target scene and the spatial layout diagram corresponding to the target scene; and wherein the environmental model is configured to describe at least one state of the first target object and of each second target object in the target scene.

An apparatus for displaying an environmental model, wherein the apparatus includes: a model display module configured to display an environmental model corresponding to a target scene; wherein the environmental model includes at least one state of first target objects and second target objects in the target scene; the environmental model generated based on a spatial layout diagram of the target scene and positions of the second target objects in the target scene; and wherein the spatial layout diagram is generated based on a relationship between a trajectory of each first target object in the target scene and each space in the target scene; a display update module configured to, when a change in at least one state of the first target objects and the second target objects is recognized, display at least one of an updated first target object and of an updated second target object in the environmental model.

Based on another aspect of the present disclosure, an electronic device includes at least one processor and at least one memory, wherein computer readable instructions are stored on the memory; when the computer readable instructions are performed by one or more of the processors, the method for generating an environmental model described above is implemented.

Based on another aspect of the present disclosure, a computer readable storage medium has computer readable instructions stored thereon, which, when performed by one or more processors, implement the method for generating an environmental model described above.

Based on another aspect of the present disclosure, a computer program product includes computer readable instructions, which, when performed by a processor, implement the method for generating an environmental model described above.

### BRIEF DESCRIPTION OF THE DRAWINGS

To illustrate the technical solutions provided in this disclosure more clearly, a brief introduction will be given below to the accompanying drawings used in the description of various embodiments of the present disclosure.
FIG. 1 is a schematic diagram of an implementation environment involved in the embodiments of the present disclosure.
FIG. 2 is a flowchart illustrating a method for generating an environmental model based on an exemplary embodiment.
FIG. 3 is a schematic diagram showing a spatial layout diagram corresponding to a smart home scene based on an exemplary embodiment.
FIG. 4a is a schematic diagram illustrating an environmental model of a smart home scene based on an exemplary embodiment.
FIG. 4b is a schematic diagram illustrating an environmental model of a smart home scene based on another exemplary embodiment.
FIG. 5 is a flowchart illustrating a method for generating an environmental model based on an exemplary embodiment.
FIG. 6 is a flowchart illustrating a method for generating an environmental model based on an exemplary embodiment.
FIG. 7 is a flowchart illustrating a method for generating an environmental model based on an exemplary embodiment.
FIG. 8 is a flowchart illustrating a method for generating an environmental model based on an exemplary embodiment.
FIG. 9 is a flowchart of a generation process of a method for generating an environmental model based on an exemplary embodiment.
FIG. 10 is a schematic diagram illustrating the generation process of the spatial layout diagram corresponding to a target scene based on an exemplary embodiment.
FIG. 11 is a flowchart illustrating a method for displaying an environmental model based on an exemplary embodiment.
FIG. 12 is a structural block diagram of an apparatus for generating an environmental model based on an exemplary embodiment.
FIG. 13 is a structural block diagram of an apparatus for displaying an environmental model based on an exemplary embodiment.
FIG. 14 is a hardware structural diagram of an electronic device based on an exemplary embodiment.
FIG. 15 is a structural block diagram of an electronic device based on an exemplary embodiment.

### DETAILED DESCRIPTION

To describe the technical solutions provided in this disclosure more clearly, the accompanying drawings used in the description of the various embodiments are briefly introduced below.

As noted above, the related art still lacks a solution for intuitively monitoring each smart device in a scene, thereby impairing the effectiveness of the device control service.

Taking a smart home scene as an example, most existing solutions merely obtain a floor plan formed by the edges of family rooms, but may not obtain the positions of various smart devices in that smart home scene; therefore, they are unable to associate those smart devices with the family rooms, and thus may not perform room based intuitive monitoring for the devices in that smart home scene.

At present, monitoring of various smart devices in a smart home scene mainly relies on a user terminal. For instance, in such a scene, the user terminal receives device state data reported by an air conditioner in the living room, determines whether the air conditioner is on, its temperature, and its operating mode, and displays the information. Under this monitoring scheme, however, the user may not intuitively monitor each smart device in the smart home scene, which affects the effectiveness of the device control service. Moreover, especially for non smart devices in the smart home scene, effective monitoring is difficult. Since non smart devices are also important environmental factors, this further increases the difficulty of improving the effectiveness of the whole-house device control service.

From the above, it may be seen that the related art still suffers from low effectiveness of device control services.

To this end, the method for generating an environmental model provided in this disclosure may generate an environmental model corresponding to a target scene, which is configured to describe the states of the second target objects in the scene. By associating each second target object with the spatial layout diagram corresponding to the target scene through this environmental model, a spatial location based device monitoring solution is realized, thereby effectively improving the effectiveness of the device control service. Correspondingly, this method is applicable to an apparatus for generating an environmental model, and the apparatus may be deployed on an electronic device, for example, a smartphone, a tablet computer.

To make the objectives, technical solutions, and advantages of this disclosure clearer, the embodiments of this disclosure are described in further detail below with reference to the accompanying drawings.

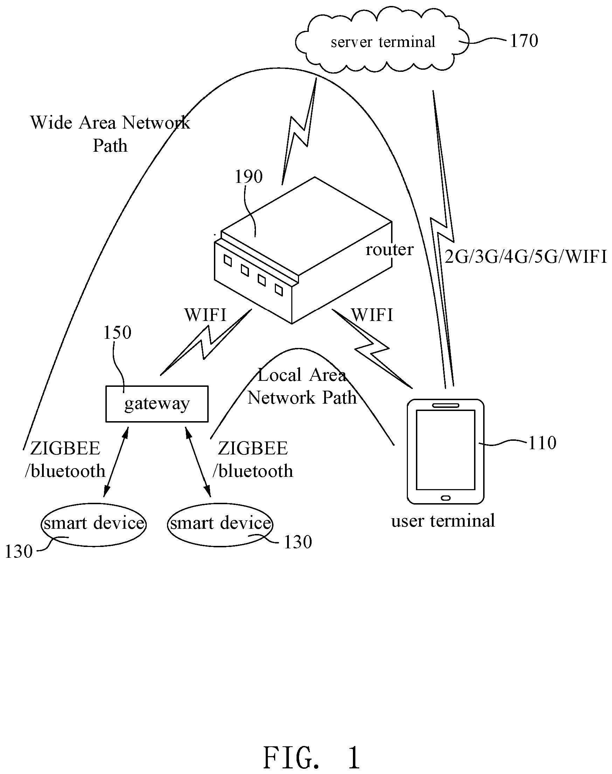

FIG. 1 is a schematic diagram of an implementation environment involved in the method for generating an environmental model. The environment at least includes a user terminal 110, a smart device 130, a server 170, and network devices; in FIG. 1, the network devices include a gateway 150 and a router 190, without limitation thereto.

The user terminal 110, also referred to as the client or terminal, may deploy (i.e., install) a client application associated with the smart device 130. The user terminal 110 may be a smartphone, a tablet computer, a notebook computer, a desktop computer, a smart control panel, or another electronic device with display and control functions, without limitation.

The client application, associated with the smart device 130, essentially allows the user to register an account and configure the smart device 130, for example, adding a device identifier, so that when the client application runs on the user terminal 110, it may provide device display and device control functions for the smart device 130. The client application may be in the form of an application program or a web page; correspondingly, the interface for device display may be a program window or a web page, without limitation.

The smart device 130 is deployed in the gateway 150 and communicates with the gateway 150 via its own communication module, thereby being controlled by the gateway 150. It should be understood that smart device 130 refers to one of many smart devices; the embodiments merely take smart device 130 as an example, and do not limit the number or type of smart devices deployed in the gateway 150. In one application scene, the smart device 130 accesses the gateway 150 via a local area network (LAN). The process includes: the gateway 150 first establishes a LAN, the smart device 130 connects to the gateway 150, and thus joins the LAN established by the gateway 150. The LAN includes, but is not limited to, Zigbee or Bluetooth. The smart device 130 may be a smart printer, smart fax machine, smart camera, smart air conditioner, smart door lock, smart light, or a human body sensor, door window sensor, temperature humidity sensor, water leak sensor, natural gas alarm, smoke alarm, wall switch, wall socket, wireless switch, wall-sticker switch, magic cube controller, curtain motor, millimeter wave radar, equipped with a communication module.

Here it is noted that the millimeter wave radar may emit an FMCW signal toward other smart devices 130, then receive the echo signals reflected by those smart devices 130, or capture the micro-doppler signal generated while other smart devices 130 are operating, thereby receiving the echo signals. Because the echo signals contain all distance segments, any moving object in the radar's detection range may be detected. Based on this characteristic, the millimeter wave radar may effectively monitor other smart devices. The micro-doppler signal refers to the vibration wave generated by a smart device 130 while working, for example, a smart air conditioner, fan, robot vacuum, air purifier, or rotating computer chassis may all produce micro-doppler signals.

Interaction between the user terminal 110 and the smart device 130 may be realized through a LAN or through a wide area network. In one application scene, the user terminal 110 establishes a wired or wireless communication connection with the gateway 150 via the router 190, for example, via WiFi, so that the user terminal 110 and the gateway 150 are in the same LAN, and the user terminal 110 may interact with the smart device 130 via the LAN path. In another application scene, the user terminal 110 establishes a wired or wireless communication connection with the gateway 150 via the server 170, for example, via 2G, 3G, 4G, 5G, WiFi, so that the user terminal 110 and the gateway 150 are in the same WAN, and the user terminal 110 may interact with the smart device 130 via the WAN path.

The server 170, also called the cloud, cloud platform, platform end, or service end, may be a single server, a server cluster composed of multiple servers, or a cloud-computing center composed of multiple servers, to better provide back-end services to massive user terminals 110, for example, device control services.

In one application scene, after the user terminal 110 obtains the spatial layout diagram corresponding to the target scene based on the relationship between the moving trajectory of the first target object in the target scene and the spaces in the scene, it may display the spatial layout diagram. Then, by receiving the echo signals captured by the smart devices 130, it identifies each second target object deployed in the target scene, obtains the position of each second target object, and generates an environmental model of the target scene based on the positions of the second target objects and the spatial layout diagram. This environmental model describes the states of the second target objects in the target scene, enabling more effective and intuitive monitoring of each second target object and providing users with more effective device control services.

Of course, in other application scenes, the above environmental-model-generation process performed by the user terminal 110 may also be implemented by the server 170. After the server 170 generates the environmental model of the target scene, it transmits the environmental model to the user terminal 110 via the WAN path, and the user terminal 110 displays the environmental model, so that the user terminal 110 may provide users with more effective device control services based on the model.

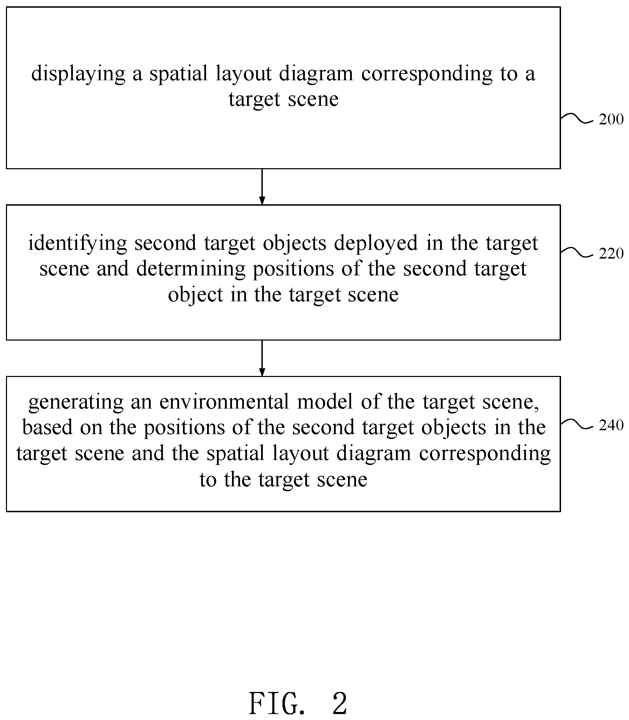

Please refer to FIG. 2. This disclosure provides a method for generating an environmental model, applicable to an electronic device, which may specifically be the user terminal 110 shown in FIG. 1.

In the following method embodiments, for ease of description, the electronic device is taken as the entity performing each step; however, this is not to be construed as a limitation. As shown in FIG. 2, the method may include the following steps:
Step 200: displaying a spatial layout diagram corresponding to a target scene.

The target scene may be an indoor or outdoor scene, for example, a smart home scene, an office scene, a park scene. The spatial layout diagram describes spatial information such as relative positions and sizes of spaces in the target scene. For instance, the spaces may be the living room or bedroom in a smart home scene, a conference room in an office scene, or an entertainment area in a park scene. In other words, the spatial layout diagram reflects boundary positions and directional relationships of the spaces in the target scene.

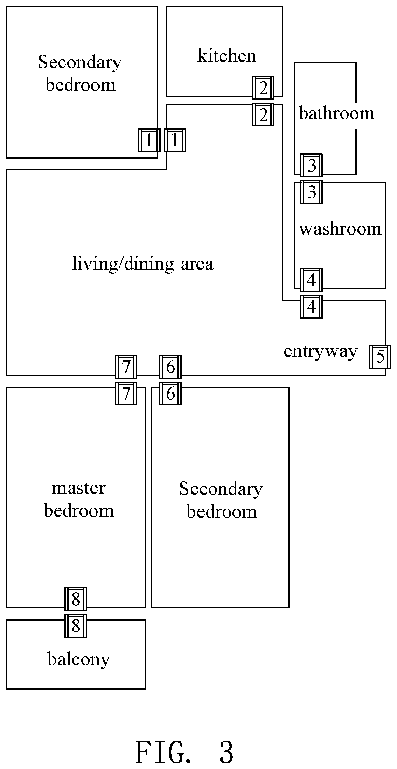

For example, the spatial layout diagram may be a floor plan. FIG. 3 shows the spatial layout diagram corresponding to the target scene where the target scene is a smart home scene. The spaces in this smart home scene at least include a secondary bedroom, kitchen, bathroom, washroom, living-dining room, two master bedrooms, and a balcony. Thus, the spatial layout diagram may reflect the boundary positions and directional relationships of the spaces in the smart home scene.

Regarding generation of the spatial layout diagram, in one possible implementation, the spatial layout diagram is generated based on the relationship between the trajectory of the first target object in the target scene and the spaces in the scene. The first target object refers to an object capable of moving in the target scene, for example, a person or a robot. The trajectory may be the movement path of the first target object in a certain area of the target scene or the motion path at a certain position, without limitation.

In one possible implementation, the electronic device may determine the spatial layout diagram of the target scene by infrared technology, for example, through the following process: the electronic device scanning the room with near-infrared light to obtain a preliminary floor plan; identifying contour jumps, removes them, and marking doorway positions and widths at the jumps; obtaining an in wall floor plan; numbers multiple doorways when a room has several; measuring wall thickness using far-infrared; stitching rooms by taking doorways as alignment references, stitching adjacent rooms at the measured wall-thickness distance, and ultimately obtaining a complete floor plan.

In another possible implementation, the spatial layout diagram may also be determined by a millimeter wave radar, for example through: filtering static points from the point cloud data to retain dynamic points; clustering dynamic points into dynamic point cloud piles; tracking the piles to obtain the tester's motion trajectory in the area to be measured; analyzing the trajectory to compute left, right, and front boundaries of the measured area. By continuously observing the person's back-and-forth motion, the radar may compute the left, right, and front boundaries of the house; through multiple measurements, the final boundaries of the area are determined.

After obtaining the spatial layout diagram corresponding to the target scene, the electronic device may display the spatial layout diagram on its screen, enabling subsequent generation of the environmental model by combining the positions of the second target objects in the target scene.

Step 220: identifying second target objects deployed in the target scene and determining positions of the second target object in the target scene.

The second target objects refer to devices or facilities deployed in the target scene. In one possible implementation, the second target objects may be devices capable of generating micro-doppler signals while operating, i.e., electronically controlled objects, for example, smart door locks, smart (electric) curtains, desktop computers, range hoods, electric fans, air conditioners. The second target objects may also be facilities incapable of generating micro-doppler signals, i.e., non electronically controlled objects, for example, sofas, wardrobes, bay windows in the target scene, without limitation.

Identifying the second target objects may include determining their position, object type, and operating state in the target scene, without limitation. The object type distinguishes different second target objects, which are different objects have different object types. For instance, air conditioner a and plant c have different object types, whereas air conditioner a and air conditioner b have the same object type. The operating state describes the working condition of the second target object, for example, ON state, OFF state, fault state.

When the second target object is an electronically controlled object, in one possible implementation, its position in the target scene is identified by a radar device. In another possible implementation, its operating state is also identified by the radar device.

When the second target object is a non electronically controlled object, in one possible implementation, the radar device identifies the position of the first target object interacting with the non electronically controlled object, indirectly identifying the position of the non electronically controlled object in the target scene.

When the second target object is a smart device, in one possible implementation, the electronic device combines the device state data reported by the smart device and the micro-doppler signal captured by the radar device while the second target object is operating to identify the device type of the smart device.

In one possible implementation, the user identifies the object type of the second target object by means of operating the electronic device (manual marking), image recognition, and so on.

Step 240: generating an environmental model of the target scene, based on the positions of the second target objects in the target scene and the spatial layout diagram corresponding to the target scene.

The environmental model is configured to describe at least one state of the first target object and of the second target objects in the target scene. The state may be the object type, the operating state, the position, the trajectory, or the motion state, without limitation.

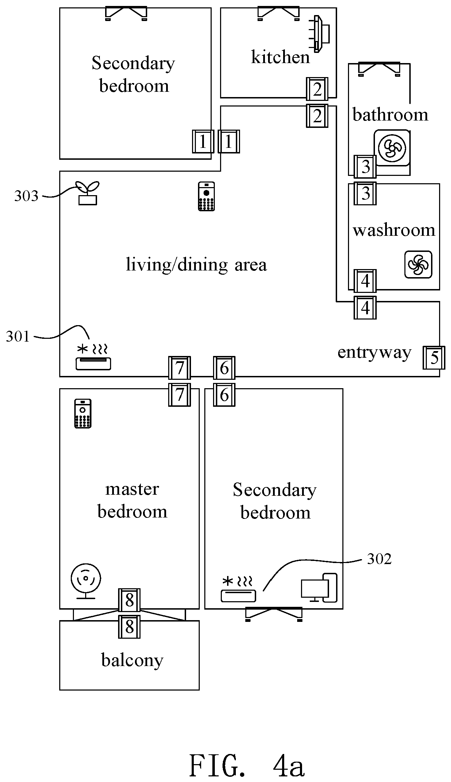

In one possible implementation, FIG. 4a shows a schematic diagram of the environmental model of the smart home scene. It may be seen that the environmental model may reflect the position, object type, and operating state of each second target object. For example, second target objects 301 and 302 have the same object type, air conditioner. Air conditioner 301 is located at the lower left of the living dining room and is OFF; air conditioner 302 is located at the lower left of the master bedroom and is ON. Second target object 303 has the object type "plant", is located at the upper left of the living dining room, and has no operating state.

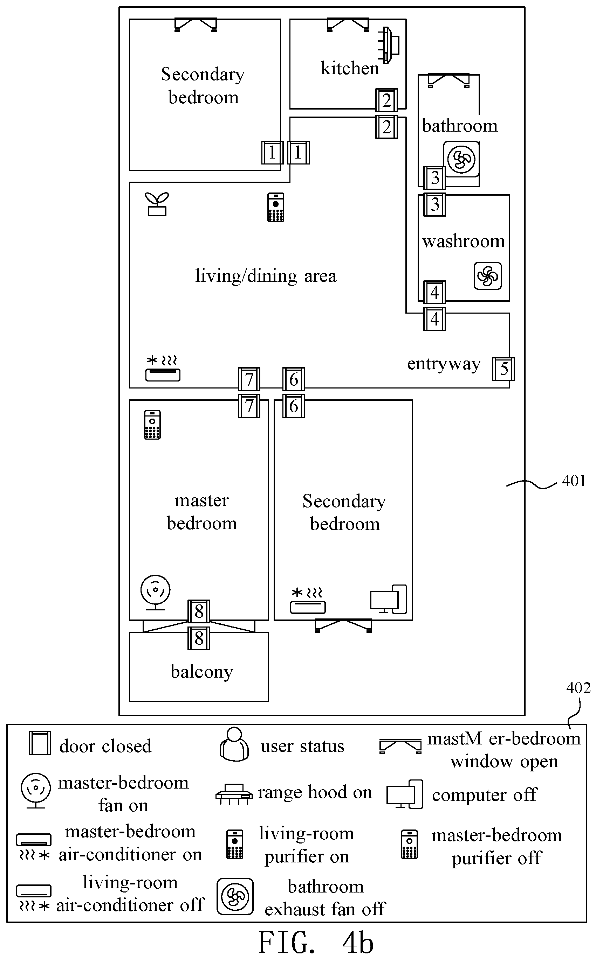

In one possible implementation, FIG. 4b shows another schematic diagram of the environmental model of the smart home scene. FIG. 4b illustrates a display area 401 of the environmental model, including the positions, object types, and operating states of the second target objects, and may also include the trajectories and motion states of the first target objects. FIG. 4b further includes a state display area 402 for at least one of the first target objects and the second target objects. This area may separately display the states of the first target objects and the second target objects in the smart home scene.

For example, in state display area 402, the electronic device may display the state of the user as the first target object, including the trajectory in the smart home scene and motion states such as stationary, seated, or fallen, obtained through human state detection. The electronic device may also display the states of various detectable devices and/or facilities as second target objects in each spatial area, for instance, all doors are closed, the master bedroom window is open, the master bedroom fan is on, the range hood is on, the computer is off, the master bedroom air conditioner is on, the living room purifier is on, the master-bedroom purifier is off, the living room air conditioner is off, the bathroom exhaust fan is off. Thus, by displaying the states of the target objects in each area of the scene via icons and text in a separate area, the electronic device enables more intuitive knowledge of the states of each first target object and each second target object in the target scene.

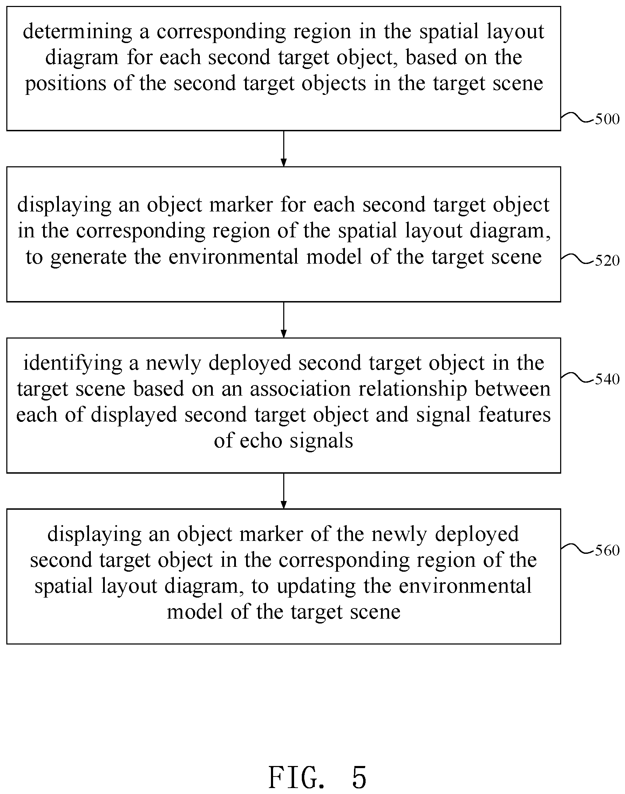

In one possible implementation, the environmental model is realized by displaying object markers of the second target objects in the spatial layout diagram. Specifically, as shown in FIG. 5, step 240 may include the following steps:
Step 500: determining a corresponding region in the spatial layout diagram for each second target object, based on the positions of the second target objects in the target scene.

That is, the electronic device maps the positions of the second target objects in the target scene into the coordinate system of the spatial layout diagram, thereby mapping those positions to the corresponding regions in the spatial layout diagram.

Step 520: displaying an object marker for each second target object in the corresponding region of the spatial layout diagram, to generate the environmental model of the target scene.

The object marker for the second target objects is configured to indicate a state of the second target object.

In one possible implementation, the object markers of the second target objects may be icons of different shapes and colors, where the shape and color respectively indicate the object type and operating state of the second target object. Using FIG. 4a as an example: marker 301 has an air conditioner shape and a light-gray color, indicating the object type is air conditioner and the operating state is OFF ("AC OFF"); marker 302 has an air conditioner shape and a dark-black color, indicating the object type is air conditioner and the operating state is ON ("AC ON"); marker 303 has a plant shape, indicating the object type is plant, and it has no operating state. Additionally, the position of the marker in the environmental model corresponds to the position of the second target object in the target scene, so the environmental model also reflects the position of the second target object.

Through the above process, a spatial location based device monitoring solution is provided: the electronic device uses the environmental model to associate each second target object in the target scene with the spatial layout diagram corresponding to the target scene, thereby enabling intuitive, dynamic, and real-time monitoring of each second target object (i.e., various devices and facilities) in the target scene, promptly grasping the operating states of those devices and facilities, and thus facilitating improvements in the effectiveness of the device control service.

Please refer to FIG. 5. In one exemplary embodiment, after step 520, the method may further include the following steps:

Step 540: identifying a newly deployed second target object in the target scene based on an association relationship between each of displayed second target object and signal features of echo signals.

The echo signals are obtained by a radar device capturing micro-doppler signals generated while the second target objects are operating.

It should be understood that, because the object types of the second target objects differ, the micro-doppler signals produced during operation generate echo signals with distinct features. Based on this, the electronic device may identify newly deployed second target objects of the same object type as those already shown in the environmental model. Specifically, for each second target object already displayed in the environmental model, the signal features of its corresponding echo signal have been associated with that object; therefore, the electronic device may identify a newly deployed second target object by leveraging this association relationship.

For example, the object types of a range hood and an exhaust fan are different; the echo signals formed by their operating micro-doppler signals are also different. The electronic device associates each object with the corresponding signal features. When a new exhaust fan is deployed, its object type may be identified by matching its echo signal with the established association relationship.

Step 560: displaying an object marker of the newly deployed second target object in a corresponding region of the spatial layout diagram, to update the environmental model of the target scene.

In one possible implementation, the electronic device obtains the position of the newly deployed second target object in the target scene based on the echo signal it generates, determines the corresponding region of the newly deployed second target object in the spatial layout diagram, and updates the environmental model, that is, places the marker of the newly deployed second target object in the corresponding region.

In addition to updating the environmental model by identifying newly deployed second target objects, the electronic device may also update the model by identifying changes in the operating state of second target objects already displayed in the environmental model. For example, each time the exhaust fan is turned on, the millimeter wave radar receives the same echo signal, which disappears when the fan is turned off. The electronic device establishes an association between this echo signal and the exhaust fan's operating state; by detecting the presence or absence of a similar echo signal, it may identify whether the exhaust fan is currently ON or OFF and update the environmental model accordingly, ensuring that the model dynamically reflects the real-time operating states of the second target objects.

Through the above process, the electronic device learns the signal features of the echo signals reflected or scattered by displayed second target objects, establishes an association between particular echo signal features and the object type and operating state of each second target object, and thereby identifies the object type and/or operating state of a newly deployed second target object based on its echo signal features. This updates the environmental model, ensuring that it dynamically reflects changes and real-time operating states of the second target objects in the target scene, further enhancing real-time monitoring capability of the devices and facilities and improving the effectiveness of the device control service.

As previously described, second target objects refer to devices or facilities deployed in the target scene and specifically include electronically controlled objects and non electronically controlled objects.

An electronically controlled object is a device capable of generating micro-doppler signals while operating; a non electronically controlled object is a facility incapable of generating such signals. A micro-doppler signal is a vibration wave actively or passively generated by a second target object during operation, for example, plants moved by wind, pulled curtains, air conditioners, fans, robot vacuums, pans heated on stoves, air purifiers, or computer cases with rotating fans may all produce micro-doppler signals.

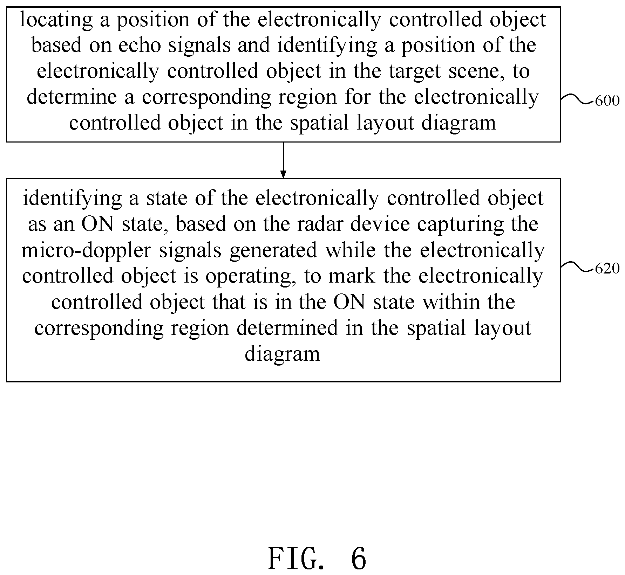

Below, with reference to FIGS. 6 to 8, the identification of each second target object deployed in the target scene is described in detail.

FIG. 6 shows that, in an exemplary embodiment, when the second target object is an electronically controlled object, step 220 may include the following:
Step 600: locating a position of the electronically controlled object based on echo signals and identifying a position of the electronically controlled object in the target scene, to determine a corresponding region for the electronically controlled object in the spatial layout diagram.

The echo signals are obtained by a radar device capturing micro-doppler signals generated while the electronically controlled object is operating.

In this way, the electronic device uses the radar to locate the electronically controlled object in the target scene and establishes an accurate mapping between the object and the spatial layout diagram, so that the environmental model becomes more accurate and the environment supervision capability is enhanced.

In FIG. 6, when the second target object is an electronically controlled object, step 220 may further include step 620: identifying a state of the electronically controlled object as an ON state, based on the radar device capturing the micro-doppler signals generated while the electronically controlled object is operating, to mark the electronically controlled object that is in the ON state within the corresponding region determined in the spatial layout diagram.

That is to say, when the electronically controlled object starts to operate, a specific micro-doppler signal always appears in the corresponding region; the electronic device may therefore identify that the operating state of the object is ON by capturing the micro-doppler signals.

This mode realizes identification of the operating state of the electronically controlled object and uses the state as a basis for generating the environmental model, so that the operating states of the respective second target objects in the target scene may be grasped in real time and dynamically, thereby enabling effective supervision of the second target objects and improving the supervision capability for devices and facilities.

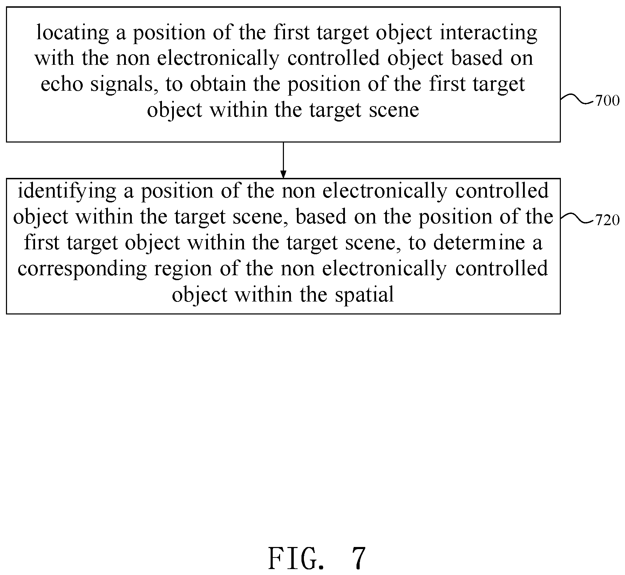

When the second target object is a non electrically controlled object, as shown in FIG. 7, step 220 may further include the following steps:
Step 700: locating a position of the first target object interacting with the non electronically controlled object based on echo signals, to obtain the position of the first target object within the target scene.

The echo signals are generated by reflection of a transmission signal, emitted by the radar device, from the first target object.

The first target object is an object capable of moving in the target scene, for example a person or a robot. The non electrically controlled object is a facility incapable of generating micro-doppler signals, for example a sofa.

Step 720: identifying a position of the non electronically controlled object within the target scene, based on the position of the first target object within the target scene, to determine a corresponding region of the non electronically controlled object within the spatial layout diagram.

For example, when a person sits down on the sofa, the electronic device locates the person based on the echo signal, obtains the position of the person in the target scene, and further calculates the edge area of the sofa according to the person's position and approximate height, thereby identifying the position of the sofa in the target scene.

In the above process, the inventors recognized that a non electrically controlled object may not generate micro-doppler signals, and that the radar device has poor capability of identifying and locating stationary objects, so it is difficult to locate the non electrically controlled object directly. Therefore, for a non electrically controlled object, the electronic device locates the first target object interacting with the non electrically controlled object, obtains the position of the first target object, and indirectly identifies the position of the non electrically controlled object in the target scene, overcoming the defect that the non electrically controlled object is difficult to supervise effectively, and ensuring that the non electrically controlled object, as an important environmental factor, may also provide device control services for the user.

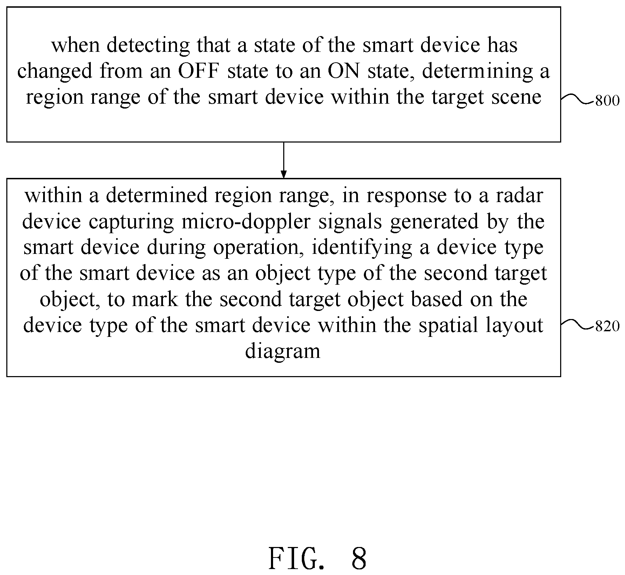

In another case, the second target object is an unknown smart device; accordingly, as shown in FIG. 8, in an exemplary embodiment, step 220 may further include the following steps: Step 800: when detecting that a state of the smart device has changed from an OFF state to an ON state, determining a region range of the smart device within the target scene.

It should be noted that the smart device whose operating state may be detected here is a known smart device already deployed in the gateway 150 in the implementation environment shown in FIG. 1; the smart device may report device state data via the gateway 150, so that the server 170/user terminal 110 may detect whether the operating state of the smart device has changed.

For example, the operating state of a smart air conditioner in the bedroom changes from OFF to ON; the smart air conditioner reports its device state data through the network device, the data indicating the operating state of the smart air conditioner. After the server or the user terminal detects the state change, it first determines the region range of the smart air conditioner in the smart home scene, to subsequently determine, within the bedroom region, whether an unknown second target object that generates micro-doppler signals while operating exists, and further determine the object type of the second target object.

Step 820: within a determined region range, in response to a radar device capturing micro-doppler signals generated by the smart device during operation, identifying a device type of the smart device as an object type of the second target object, to mark the second target object based on the device type of the smart device within the spatial layout diagram.

Continuing the above example, within the bedroom region the radar device receives echo signals and thereby captures the micro-doppler signals generated while the second target object is operating; based on the state change detected in step 800, the electronic device associates the smart device whose operating state has changed with the second target object detected by the radar, i.e. determines that the second target object is the bedroom smart air conditioner, thus completing the identification of the object type of the second target object.

In the above process, thanks to the IoT attribute of the smart device, the device state data of all smart devices deployed in the gateway may be acquired by the electronic device, so that an unknown smart device is linked with a known smart device, and the electronic device may determine the object type of the second target object, namely the device type of the corresponding smart device, which is conducive to effective supervision of each smart device in the target scene and improves the effectiveness of device control services.

For the second target objects in the target scene, in addition to automatic identification by the electronic device, other manners may be used; in an exemplary embodiment, step 220 may further include: in response to a type marking operation for the second target object, identifying an object type of the second target object; or in response to an identification event triggered by an image capturing device for the second target object, identifying the object type of the second target object.

In a possible implementation, the type marking operation may be a manual marking operation by the user, so that the identification of the object type of the second target object is completed through manual marking. The manual marking operation may be initiated actively by the user or passively prompted by the electronic device, for example the electronic device generates a marking-prompt message to ask the user to perform manual marking, which is not limited herein.

The image capturing device may be a camera, a smartphone with a camera; the identification event may be that the image capturing device captures an image containing the second target object and performs image recognition on the image, thereby identifying the object type of the second target object.

By identifying the object type through the type marking operation or the identification event triggered by the image capturing device, the electronic device provides further identification methods and enhances the supervision capability of the environmental model for devices and facilities (i.e. second target objects) in the target scene.

With the cooperation of the above embodiments, the disclosure fully considers that second target objects of different forms may exist in the target scene, provides different identification methods for different second target objects, meets the identification requirements for various second target objects, may identify more devices and facilities in the target scene, and may identify each second target object more accurately.

With the coordination of the above embodiments, full consideration is given to the possibility that second target objects of different forms may exist in the target scene; different identification methods are provided for different second target objects, to meet the identification requirements for different second target objects, thereby enabling more devices and facilities in the target scene to be identified and enabling each second target object to be identified more accurately. By acquiring the position, operating state and object type of each second target object, the electronic device generates an environmental model, which facilitates the user in intuitively knowing the position, object type or operating state of each second target object in the target scene, and enables dynamic and real-time supervision of the devices and facilities in the target scene.

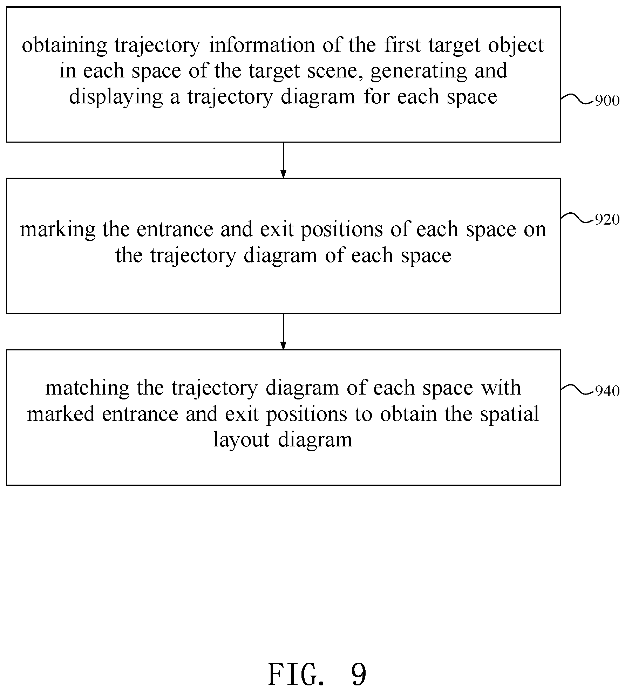

Referring to FIG. 9, in an exemplary embodiment, before step 200 the method may further include the following steps:
Step 900: obtaining trajectory information of the first target object in each space of the target scene, generating and displaying a trajectory diagram for each space.

The trajectory information is configured to indicate movement trajectories of the first target object in each space.

In a possible implementation, the electronic device uses the radar device to locate the first target object to acquire the trajectory information.

Specifically, step 900 includes: tracking a trajectory of the first target object based on echo signals generated by reflection of radar transmission signals from the first target object, to obtain the trajectory information of the first target object in each space.

Step 920: marking the entrance and exit positions of each space on the trajectory diagram of each space.

In a possible implementation, the electronic device determines the entrance and exit positions of each space by detecting an open and close action of the first target object in the space.

Specifically, step 920 may include: step 921, in response to a spatial open and close event triggered in each space, respectively determining positions of the first target object in each space at the moment when the spatial open and close event is triggered.

The spatial open and close event is a door open and close event, and the first target object may be a person; the moment when the spatial open and close event is triggered is the moment when the person opens or closes the door.

Accordingly, at the moment when the person opens or closes the door of a space, the radar device locates the person, and the electronic device thereby uses the position of the person as the entrance and exit positions of the space.

Step 922: marking the entrance and exit positions of each space at corresponding regions on the trajectory diagram of each space based on determined positions.

It may be understood that when the person opens or closes the door, the position of the person coincides with the entrance and exit positions of the space, so the electronic device may mark the entrance and exit positions on the trajectory diagram of each space according to the position of the person at that moment.

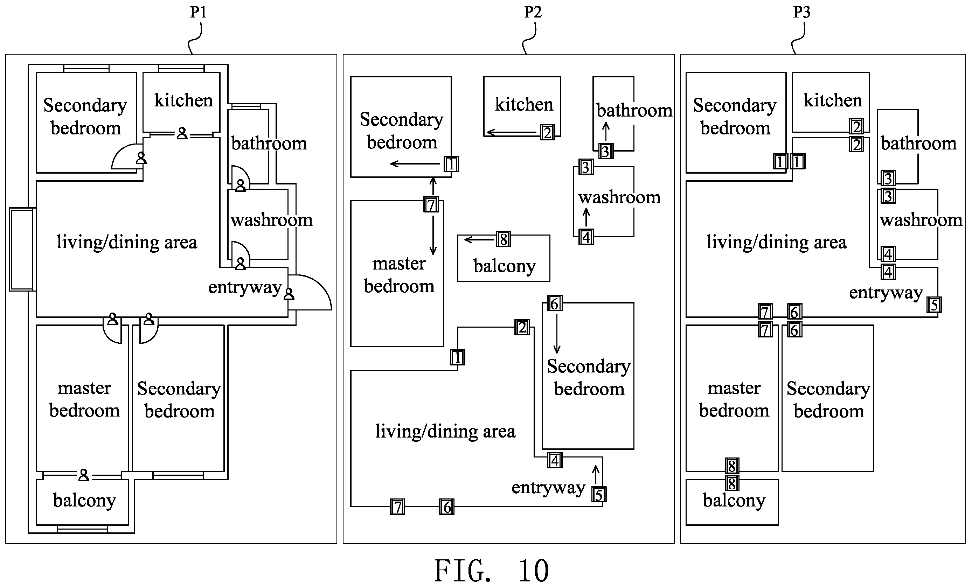

As shown in FIG. 10, because one entrance and exit position connects two adjacent spaces, one entrance and exit position is marked on the trajectory diagrams of two different spaces. In a possible implementation, the user manually marks an access location through the electronic device to determine the entrance and exit position.

Specifically, step 920 may further include: step 924, in response to a marking operation on an access location, determining two adjacent spaces associated with the access location.

The access location is configured to indicate the position at which the first target object passes when entering or exiting between the two adjacent spaces. The marking operation on the access location may be performed manually by the user.

Step 925: marking the access location on trajectory diagrams of the two adjacent spaces as the entrance and exit positions for the two adjacent spaces.

Step 940: matching the trajectory diagram of each space with marked entrance and exit positions to obtain the spatial layout diagram.

The matching connects the trajectory diagrams of the spaces marked with the entrance and exit positions according to the spatial orientation relationships and the entrance and exit positions, thereby obtaining the spatial layout diagram.

Referring to FIG. 10, an exemplary embodiment illustrates generating the spatial layout diagram corresponding to the target scene.

The target scene P1 is a smart home scene; the first target object (i.e. the user) moves in each space of the target scene P1, and the electronic device tracks the first target object (user) by means of the radar device to obtain trajectory information of the first target object in each space. For example, in P1 of FIG. 10 the trajectory information includes the movement trajectory of the user in each space (shown as a user movement route line), the electronic device thereby generates and displays the trajectory diagram P2 of each space, and, at the moment when a spatial open and close event is triggered, locates the first target object and marks the entrance and exit positions at the corresponding region on the trajectory diagram of each space. Finally, the electronic device matches the trajectory diagrams of the spaces that have been marked with the entrance and exit positions to obtain the spatial layout diagram, based on the entrance and exit positions and the movement direction of the user.

Under the effect of the above embodiments, the spatial layout diagram is generated based on the relationship between the movement trajectory of the first target object in the target scene and the respective spaces of the target scene, providing a method for generating a spatial layout diagram by tracking a target object, which is simpler, more convenient and more efficient than related-art solutions.

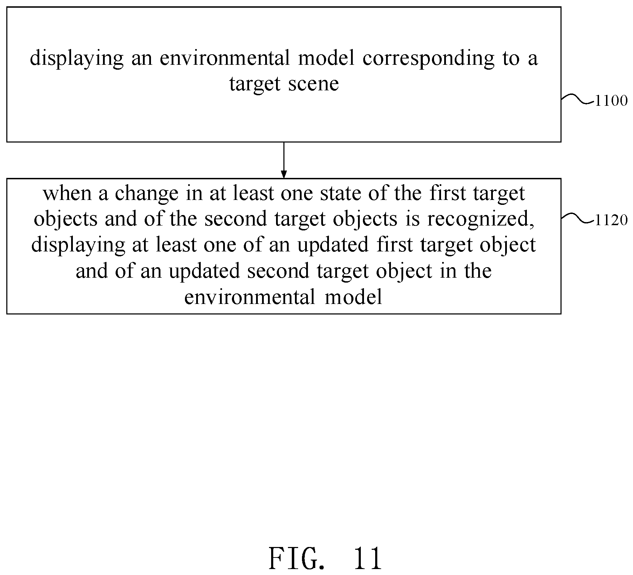

Referring to FIG. 11, the present disclosure provides a method for displaying an environmental model, applicable to an electronic device, which may specifically be the user terminal 110 shown in the implementation environment of FIG. 1.

In the following method embodiments, for convenience of description, the electronic device is taken as the subject executing each step, but this is not limiting. As shown in FIG. 11, the method may include the following steps:
Step 1100: displaying an environmental model corresponding to a target scene.

First, it is noted that the environmental model includes at least one state of the first target objects and/or state of the second target objects in the target scene. The state may be the object type and/or the operating state of the first target objects and/or the second target objects in the target scene, and may also be the position, trajectory and/or motion state of the first target objects and/or the second target objects in the target scene, without limitation.

The environmental model of the target scene is generated by the electronic device based on the spatial layout diagram of the target scene and the positions of the second target objects in the target scene.

Secondly, the first target object is an object capable of moving in the target scene, for example a person or a robot, so that the electronic device may generate the spatial layout diagram based on the relationship between the trajectory of the first target object in the target scene and the respective spaces of the target scene, and then use it as a basis for generating the environmental model of the target scene. The trajectory may be the movement trajectory of the first target object in a certain area or at a certain position in the target scene, without limitation.

The second target object refers to a device or facility deployed in the target scene. In a possible implementation, the second target object may be a device capable of generating micro-doppler signals while operating, namely an electronically controlled object, such as a smart door lock, a smart (electric) curtain, a desktop computer, a range hood, an electric fan, an air conditioner; the second target object may also be a facility incapable of generating micro-doppler signals, namely a non electrically controlled object, such as a sofa, a wardrobe, a bay window in the target scene, without limitation.

Step 1120: when a change in at least one state of the first target objects and of the second target objects is recognized, displaying at least one of an updated first target object and of an updated second target object in the environmental model.

The states of the first target objects and/or the second target objects may be represented by different object markers, which may be icons of different shapes and colors, so that the electronic device may represent the states of the first target objects and/or the second target objects by icons of different shapes and colors, the states including but not limited to object type, operating state, position.

Referring back to FIG. 4a, the object marker 301 has the shape of an air conditioner and is light gray, indicating that the object type of the second target object is an air conditioner and its operating state is OFF, i.e. "AC OFF"; the object marker 302 has the shape of an air conditioner and is dark black, indicating that the object type of the second target object is an air conditioner and its operating state is ON, i.e. "AC ON"; the object marker 303 has the shape of a green plant, indicating that the object type of the second target object is a green plant. It is noted that some second target objects have no operating-state attribute. In addition, the position of an object marker in the environmental model may map the position of the corresponding second target object in the target scene, so that the environmental model substantially also reflects the position of the second target object in the target scene.

Referring back to FIG. 4b, a schematic diagram of an environmental model of a smart home scene is shown. FIG. 4b illustrates a graphical portion 401 of the environmental model of the smart home scene, including the positions, object types and operating states of the respective second target objects in the smart home scene, and may also include at least one of the trajectories and motion states of the respective first target objects in the smart home scene. FIG. 4b further includes a state display area 402 for the first target objects and/or the second target objects, where the states of the first target objects in the smart home scene and the states of the second target objects in the smart home scene may be displayed separately. By displaying the states of the target objects in each area of the target scene in the form of icons and text in an additional area, the user may more intuitively know the states of the first target objects and the second target objects in the target scene.

Through the above embodiments, the electronic device displays the environmental model on the interface of the electronic device, and timely updates the displayed environmental model based on the state changes of the first target objects and/or the second target objects, so that the user may more intuitively and real-timely grasp the states of the first target objects and/or the second target objects in the target scene.

Compared with the related art, the embodiments of the present disclosure have the following beneficial effects:

1. The environmental model is configured to describe the object type and/or state of the second target objects in the target scene, enabling device-and-facility supervision based on spatial positioning, so that the user may remotely and intuitively grasp the real time states of the devices and facilities in the target scene, to further manage these devices and facilities.

2. The electronic device generates the spatial layout diagram of the target scene based on the relationship between the movement trajectory of the first target object in the target scene and the respective spaces of the target scene, identifies the second target objects deployed in the target scene to obtain the positions of the second target objects in the target scene, and then generates the environmental model of the target scene based on the spatial layout diagram of the target scene and the positions of the second target objects in the target scene, the environmental model being configured to describe the object type and/or state of the second target objects in the target scene. Thereby, the electronic device associates the second target objects with the spatial layout diagram, provides an environment supervision method based on spatial positioning, and may intuitively, dynamically and real-timely supervise the various devices and facilities in the target scene through the environmental model, obtain the states of the second target objects (i.e. the devices and facilities) in the target scene in real time, and improve the real-time supervision and management capability for the devices and facilities in the target scene. The solution of the present disclosure may help the user intuitively supervise the devices and facilities in the target scene, understand the real time states of the different devices, to manage the devices in the target scene.

3. The electronic device learns the signal features of the echo signals reflected/scattered by the already-displayed second target objects, establishes an association between the specific signal features and the object type and state of the second target objects, and thereby identifies the object type and/or state of a newly deployed second target object through the signal features of the echo signals reflected/scattered by the newly deployed second target object, and updates the environmental model accordingly. Of course, for a second target object already displayed in the environmental model, the electronic device may identify its state through the signal features of its echo signals and update the environmental model. Updating the environmental model ensures that the environmental model dynamically reflects the real time states of the second target objects in the target scene, and may also present the newly deployed second target object in the environmental model in time after the new deployment, further enhancing the real-time supervision capability for the target scene.

4. Considering that a non electrically controlled object may not generate micro-doppler signals and that the radar device has poor capability of identifying and locating stationary objects, i.e. it is difficult to locate the non electrically controlled object directly, the electronic device, for a non electrically controlled object, locates the first target object interacting with the non electrically controlled object, obtains the position of the first target object, and indirectly identifies the position of the non electrically controlled object in the target scene, overcoming the defect that the non electrically controlled object is difficult to locate effectively.

5. Thanks to the IoT attribute of the smart device, the data information of the smart device may be acquired by the electronic device. When the electronic device detects that the operating state of the smart device has changed from OFF to ON, it captures, within the corresponding region range, the micro-doppler signals generated while the second target object is operating by means of the radar, i.e. discovers the second target object, and associates the discovered second target object with the smart device, so that the object type of the second target object, namely the device type of the corresponding smart device, may be determined. The above embodiment provides an identification method for smart devices, meeting the identification requirements for different second target objects.

6. The disclosure fully considers that second target objects of different forms may exist in the target scene, provides different identification methods for different second target objects, meets the identification requirements for various second target objects, may identify more devices and facilities in the target scene, and may identify each second target object more accurately. The electronic device may obtain the position, state and object type of each second target object, generate the environmental model, enable the user to intuitively know the position, object type or state of each second target object in the target scene, and supervise the devices and facilities in the target scene dynamically and in real time.

7. The spatial layout diagram is generated based on the relationship between the movement trajectory of the first target object in the target scene and the respective spaces of the target scene, providing a method for generating a spatial layout diagram by tracking a target object, which is simpler, more convenient and more efficient than related-art solutions.

It should be understood that, although the steps in the flowcharts of FIGS. 2, 5 to 9 and 11 are shown in sequence according to the arrows, the steps are not necessarily performed in the order indicated by the arrows. Unless explicitly stated herein, the execution of the steps is not strictly sequential, and may be performed in other orders. Moreover, at least some of the steps in FIGS. 2, 5-9 and 11 may include a plurality of sub-steps or stages, which are not necessarily completed at the same time, but may be executed at different times, and the order of execution is not necessarily sequential, but may be performed alternately with other steps or sub-steps or stages of other steps.

The following are apparatus embodiments of the present disclosure, which may be configured to perform the environment model-generation method involved in the present disclosure. For details not disclosed in the apparatus embodiments, reference is made to the method embodiments of the environment model-generation method involved in the present disclosure.

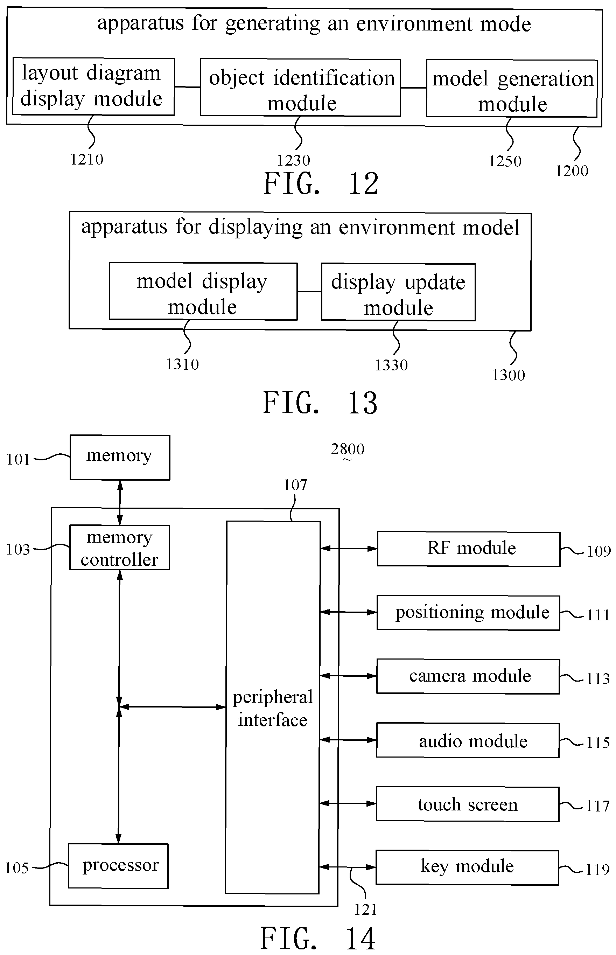

Referring to FIG. 12, an embodiment of the present disclosure provides an apparatus for generating an environment model 1200, including but not limited to a layout diagram display module 1210, an object identification module 1230, and a model generation module 1250.

The layout diagram display module 1210 is configured to display a spatial layout diagram corresponding to a target scene; wherein the spatial layout diagram is generated based on a relationship between a trajectory of a first target object in the target scene and each space in the target scene.

The object identification module 1230 is configured to identify second target objects deployed in the target scene and determine positions of second target objects in the target scene.

The model generation module 1250 is configured to generate the environmental model of the target scene based on the positions of the second target objects in the target scene and the spatial layout diagram corresponding to the target scene; wherein the environmental model is configured to describe at least one state of the first target object and each second target object in the target scene.

In an exemplary embodiment, the model generation module 1250 further includes: a region determination unit 1251, configured to determine, based on the positions of the second target object in the target scene, a corresponding region in the spatial layout diagram for each second target object; and a marker display unit 1252, configured to display an object marker for each second target object in the corresponding region of the spatial layout diagram, to generate the environmental model of the target scene; wherein the object marker for each second target object is configured to indicate a state of the second target object.

In an exemplary embodiment, the apparatus 1200 further includes:

an object re identification module 1270, configured to identify, based on an association relationship between each of displayed second target objects and signal features of echo signals, a newly deployed second target object in the target scene; wherein the echo signals are obtained by a radar device capturing micro-doppler signals generated while the second target objects are operating; and a model update module 1290, configured to display a object marker of the newly deployed second target object in a corresponding region of the spatial layout diagram, to update the environmental model of the target scene.

In an exemplary embodiment, the second target objects include an electronically controlled object; the electronically controlled object is a device capable of generating micro-doppler signals while operating; the object identification module 1230 may further include: a first locating unit 1231, configured to locate a position of the electronically controlled object based on echo signals, and identify a position of the electronically controlled object in the target scene, to determine a corresponding region for the electronically controlled object in the spatial layout diagram; wherein the echo signals are obtained by a radar device capturing micro-doppler signals generated while the electronically controlled object is operating.

In an exemplary embodiment, the object identification module 1230 may further include: a state identification unit 1232, configured to identify, based on the radar device capturing the micro-doppler signals generated while the electronically controlled object is operating, a state of the electronically controlled object as an ON state, to mark the electronically controlled object that is in the ON state within the corresponding region determined in the spatial layout diagram.

In an exemplary embodiment, the second target objects includes a non electrically controlled object; the non electrically controlled object is a facility incapable of generating micro-doppler signals; the object identification module 1230 may further include: a second locating unit 1233, configured to locate a position of the first target object interacting with the non electrically controlled object based on echo signals, to obtain the position of the first target object within the target scene; wherein the echo signals are generated by reflection of a transmission signal, emitted by the radar device, from the first target object; and a position identification unit, configured to identify a position of the non electrically controlled object within the target scene, based on the position of the first target object in the target scene, to determine a corresponding region of the non electrically controlled object in the spatial layout diagram.

In an exemplary embodiment, the object identification module 1230 may further include: a range determination unit 1235, configured to when detecting that a state of the smart device has changed from an OFF state to an ON state, determine a region range of the smart device within the target scene; and a first type identification unit 1236, configured to identify, within a determined region range, in response to a radar device capturing micro-doppler signals generated by the smart device during operation, a device type of the smart device as an object type of the second target object, to mark the second target object based on the device type of the smart device within the spatial layout diagram.

In an exemplary embodiment, the object identification module 1230 may further include: a second type identification unit 1237, configured to identify an object type of the second target object in response to a type marking operation for the second target object, or identify the object type of the second target object in response to an identification event triggered by an image capturing device for the second target object.

In an exemplary embodiment, the apparatus 1200 may further include: a trajectory information acquisition module 1310, configured to obtain trajectory information of the first target object in each space of the target scene, generate and display a trajectory diagram for each space; the trajectory information is configured to indicate movement trajectories of the first target object in each space; an entrance and exit marking module 1330, configured to mark the entrance and exit position of each space on the trajectory diagram of each space; and a layout diagram acquisition module, configured to match the trajectory diagram of each space with marked entrance and exit positions, to obtain the spatial layout diagram.

In an exemplary embodiment, the trajectory information acquisition module 1310 includes: a trajectory tracking unit 1311, configured to track a trajectory of the first target object based on echo signals echo signals generated by reflection of radar transmission signals from the first target object, to obtain the trajectory information of the first target object in each space.

In an exemplary embodiment, the entrance and exit marking module 1330 includes: a position determination unit 1331, configured to respectively determine, in response to a spatial open and close event triggered in each space, positions of the first target object in each space at the time when the spatial open and close event is triggered.

In an exemplary embodiment, the entrance and exit marking module 1330 may further include: an adjacent space determination unit 1332, configured to determine, in response to a marking operation on an access location, two adjacent spaces associated with the access location; the access location is configured to indicate a position at which the first target object passes when entering or exiting between the two adjacent spaces.

Referring to FIG. 13, an embodiment of the present disclosure further provides an apparatus for displaying an environment model 1300, including but not limited to a model display module 1310 and a display update module 1330.

The model display module 1310 is configured to display an environmental model corresponding to a target scene; the environmental model includes at least one state of first target objects and second target objects in the target scene; wherein the environmental model is generated based on the spatial layout diagram of the target scene and the positions of the second target objects in the target scene; the spatial layout diagram is generated based on the relationship between the trajectory of each first target object in the target scene and the respective spaces of the target scene.

The display update module 1330 is configured to display, when a change in at least one state of the first target objects and the second target objects is recognized, the updated first target object and/or updated second target object in the environmental model.

In an exemplary embodiment, the model display module 1310 is further configured to display, in the environmental model, at least one of the trajectory and the motion state of each first target object in the target scene, or display, in the environmental model, at least one of the position, the object type and the operating state of each second target object in the target scene.

In an exemplary embodiment, the states of the first target objects and the second target objects include at least one of object type, operating state, position, trajectory and motion state.

It should be noted that, when the environment model generation apparatus provided in the above embodiments performs environment model generation, only the division of the functional modules is described as an example. In actual applications, the above functions may be allocated to be completed by different functional modules according to needs, that is, the internal structure of the apparatus is divided into different functional modules to complete all or part of the functions described above.

In addition, the environment model generation apparatus provided in the above embodiments and the method embodiments of the environment model generation method belong to the same concept, and the specific implementation manners of the respective modules have been described in detail in the method embodiments, which are not repeated herein.

Referring to FIG. 14, which is a structural schematic diagram of an electronic device according to an exemplary embodiment. The electronic device is applicable to the user terminal 110 shown in the implementation environment of FIG. 1.

It should be noted that the electronic device is only an example adapted to the present disclosure, and should not be considered as any limitation on the scope of use of the present disclosure, nor should it be construed that the electronic device may rely on or may have one or more components shown in the example electronic device 1400 in FIG. 14.

As shown in FIG. 14, the electronic device 1400 includes a memory 101, a memory controller 103, one or more (only one shown in FIG. 14) processors 105, a peripheral interface 107, an RF module 109, a positioning module 111, a camera module 113, an audio module 115, a touch screen 117 and a key module 119. These components communicate with each other via one or more communication buses/signal lines 121.

The memory 101 may be configured to store computer programs and modules, such as the computer programs and modules corresponding to the environment model generation method and apparatus in the exemplary embodiments of the present disclosure. The processor 105 executes the computer programs stored in the memory 101 to implement various functions and data processing, that is, to perform the environment model generation method.

The memory 101, as a resource storage carrier, may be a random access memory, such as a high-speed random access memory, or a non volatile memory, such as one or more magnetic storage devices, flash memories, or other solid-state memories. The storage manner may be temporary storage or permanent storage.

The peripheral interface 107 may include at least one wired or wireless network interface, at least one serial-parallel conversion interface, at least one input/output interface, and at least one USB interface, for coupling various external input/output devices to the memory 101 and the processor 105, to realize communication with various external input/output devices.

The RF module 109 is configured to transmit and receive electromagnetic waves, realize the mutual conversion between electromagnetic waves and electric signals, to communicate with other devices through a communication network. The communication network includes a cellular telephone network, a wireless local area network, or a metropolitan area network, and the above communication networks may use various communication standards, protocols and technologies.

The positioning module 111 is configured to obtain the current geographical location of the electronic device 1400. Examples of the positioning module 111 include but are not limited to a global positioning system (GPS), wireless local area network-based positioning technology, or mobile communication network-based positioning technology.

The camera module 113 belongs to a camera and is configured to take pictures or videos. The taken pictures or videos may be stored in the memory 101, or may be sent to a host computer through the RF module 109.

The audio module 115 provides an audio interface for the user, and may include one or more microphone interfaces, one or more speaker interfaces, and one or more headphone interfaces. Audio data is interacted with other devices through the audio interface. The audio data may be stored in the memory 101, or may be sent through the RF module 109.

The touch screen 117 provides an input/output interface between the electronic device 1100 and the user. Specifically, the user may perform input operations through the touch screen 117, such as clicking, touching, sliding and other gesture operations, so that the electronic device 1400 responds to the input operations. The electronic device 1400 displays the output content in the form of text, pictures or videos or any combination thereof to the user through the touch screen 117.

The key module 119 includes at least one key, providing an interface for the user to input to the electronic device 1400. The user may press different keys to cause the electronic device 1400 to perform different functions. For example, a volume adjustment key may be used by the user to adjust the volume of the sound played by the electronic device 1400.

It may be understood that the structure shown in FIG. 14 is only schematic, and the electronic device 1400 may also include more or fewer components than those shown in FIG. 14, or have components different from those shown in FIG. 14. The components shown in FIG. 14 may be implemented by hardware, software, or a combination thereof.

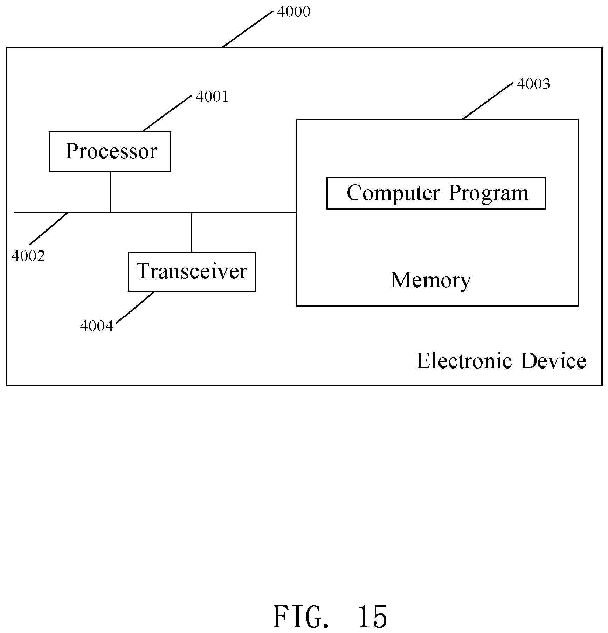

Referring to FIG. 15, an embodiment of the present disclosure provides an electronic device 4000, which may be a smartphone, a tablet computer.

In FIG. 15, the electronic device 4000 includes at least one processor 4001, at least one communication bus 4002, and at least one memory 4003.

The processor 4001 and the memory 4003 are connected, for example, via the communication bus 4002. Optionally, the electronic device 4000 may further include a transceiver 4004, which may be used for data interaction between the electronic device and other electronic devices, such as sending and/or receiving data. It should be noted that, in practical applications, the transceiver 4004 is not limited to one, and the structure of the electronic device 4000 does not constitute any limitation on the embodiments of the present disclosure.

The processor 4001 may be a CPU (Central Processing Unit), a general-purpose processor, a DSP (Digital Signal Processor), an ASIC (Application Specific Integrated Circuit), an FPGA (Field Programmable Gate Array) or other programmable logic devices, transistor logic devices, hardware components, or any combination thereof. The processor 4001 may implement or execute various exemplary logic blocks, modules and circuits described in combination with the disclosure of the present disclosure. The processor 4001 may also be a combination implementing computing functions, for example, a combination of one or more microprocessors, or a combination of a DSP and a microprocessor.

The communication bus 4002 may include a pathway for transmitting information between the above components. The communication bus 4002 may be a PCI (Peripheral Component Interconnect) bus, an EISA (Extended Industry Standard Architecture) bus. The communication bus 4002 may be divided into an address bus, a data bus, a control bus. For ease of representation, only one bold line is shown in FIG. 15, but it does not mean that there is only one bus or one type of bus.

The memory 4003 may be a ROM (Read Only Memory) or other types of static storage devices capable of storing static information and instructions, a RAM (Random Access Memory) or other types of dynamic storage devices capable of storing information and instructions, an EEPROM (Electrically Erasable Programmable Read Only Memory), a CD-ROM (Compact Disc Read Only Memory) or other optical disc storage, optical disk storage (including compressed optical disks, laser disks, optical disks, digital versatile disks, Blu-ray disks), a magnetic disk storage medium or other magnetic storage devices, or any other medium capable of carrying or storing desired program code in the form of instructions or data structures and capable of being accessed by a computer, but is not limited thereto.

Computer readable instructions are stored in the memory 4003, and the processor 4001 reads the computer readable instructions stored in the memory 4003 via the communication bus 4002.

When the computer readable instructions are executed by the processor 4001, the steps of the environment model generation method and the environment model display method in the above embodiments are implemented.

In addition, an embodiment of the present disclosure provides a computer readable storage medium, on which computer readable instructions are stored, and when the computer readable instructions are executed by a processor, the steps of the environment model generation method and the environment model display method in the above embodiments are implemented.

An embodiment of the present disclosure further provides a computer readable instruction product, where the computer readable instruction product includes computer readable instructions, and the computer readable instructions are stored in a computer readable storage medium. A processor of a computer device reads the computer readable instructions from the computer readable storage medium, and executes the computer readable instructions, so that the computer device performs the steps of the environment model generation method and the environment model display method in the above embodiments.

It should be understood that, although the steps in the flowcharts of the accompanying drawings are shown in sequence according to the arrows, the steps are not necessarily performed in the order indicated by the arrows. Unless explicitly stated herein, the execution of the steps is not strictly sequential, and may be performed in other orders. Moreover, at least some of the steps in the flowcharts may include a plurality of sub-steps or stages, which are not necessarily completed at the same time, but may be executed at different times, and the order of execution is not necessarily sequential, but may be performed alternately with other steps or sub-steps or stages of other steps.

The foregoing descriptions are merely partial embodiments of the present disclosure. It should be pointed out that, for a person of ordinary skill in the art, without departing from the principles of the present disclosure, several improvements and refinements may still be made, and such improvements and refinements shall also be regarded as falling within the scope of protection of the present disclosure.

## Claims

1. A method for generating an environmental model, performed by an electronic device, the method comprising:
displaying a spatial layout diagram corresponding to a target scene; wherein the spatial layout diagram is generated based on a relationship between a trajectory of a first target object in the target scene and each space in the target scene;
identifying second target objects deployed in the target scene and determining positions of second target objects in the target scene;
generating an environmental model of the target scene, based on the positions of the second target objects in the target scene and the spatial layout diagram corresponding to the target scene; wherein the environmental model is configured to describe at least one state of the first target object and of each second target object in the target scene.

2. The method of claim **1,** wherein generating the environmental model of the target scene, based on the positions of the second target objects in the target scene and the spatial layout diagram corresponding to the target scene, comprises:
determining a corresponding region in the spatial layout diagram for each second target object, based on the positions of the second target objects in the target scene;
displaying an object marker for each second target object in the corresponding region of the spatial layout diagram, to generate the environmental model of the target scene; wherein the object marker for each second target object is configured to indicate a state of the second target object.

3. The method of claim **2,** wherein after displaying the object marker for each second target object in the corresponding region of the spatial layout diagram, to generate the environmental model of the target scene, the method further comprises:
identifying a newly deployed second target object in the target scene based on an association relationship between each of displayed second target objects and signal features of echo signals; the echo signals obtained by a radar device capturing micro-doppler signals generated while the second target objects are operating;
displaying an object marker of the newly deployed second target object in a corresponding region of the spatial layout diagram, to update the environmental model of the target scene.

4. The method of claim **1,** wherein the second target objects comprise an electronically controlled object; the electronically controlled object is a device that produces micro-doppler signals while operating;
identifying the second target objects deployed in the target scene comprises:
locating a position of the electronically controlled object based on echo signals, and identifying a position of the electronically controlled object in the target scene, to determine a corresponding region for the electronically controlled object in the spatial layout diagram;
wherein the echo signals are obtained by a radar device capturing the micro-doppler signals generated while the electronically controlled object is operating.

5. The method of claim **4,** wherein identifying the second target objects deployed in the target scene further comprises:
identifying a state of the electronically controlled object as an ON state, based on the radar device capturing the micro-doppler signals generated while the electronically controlled object is operating, to mark the electronically controlled object that is in the ON state within the corresponding region determined in the spatial layout diagram.

6. The method of claim **1,** wherein the second target objects comprise a non electronically controlled object; wherein the non electronically controlled object is a facility incapable of generating micro-doppler signals;
identifying the second target objects deployed in the target scene comprises:
locating a position of the first target object interacting with the non electronically controlled object based on echo signals, to obtain the position of the first target object within the target scene; wherein the echo signals are generated by reflection of a transmission signal, emitted by the radar device, from the first target object;
identifying a position of the non electronically controlled object within the target scene, based on the position of the first target object within the target scene, to determine a corresponding region of the non electronically controlled object within the spatial layout diagram.

7. The method of claim **1,** wherein the second target objects comprise a smart device; identifying the second target objects deployed in the target scene comprises:
when detecting that a state of the smart device has changed from an OFF state to an ON state, determining a region range of the smart device within the target scene;
within a determined region range, in response to a radar device capturing micro-doppler signals generated by the smart device during operation, identifying a device type of the smart device as an object type of the second target object, to mark the second target object based on the device type of the smart device within the spatial layout diagram.

8. The method of claim **1,** wherein identifying second target objects deployed in the target scene comprises:
in response to a type marking operation for the second target object, identifying an object type of the second target object; or
in response to an identification event triggered by an image capturing device for the second target object, identifying the object type of the second target object.

9. The method of any one of claims 1 to **8,** wherein before displaying the spatial layout diagram corresponding to the target scene, the method further comprises:
obtaining trajectory information of the first target object in each space of the target scene, generating and displaying a trajectory diagram for each space; wherein the trajectory information is configured to indicate movement trajectories of the first target object in each space;
marking entrance and exit positions of each space on the trajectory diagram of each space;
matching the trajectory diagram of each space with marked entrance and exit positions to obtain the spatial layout diagram.

10. The method of claim **9,** wherein said obtaining the trajectory information of the first target object in each space in the target scene, comprises:
tracking a trajectory of the first target object based on echo signals generated by reflection of radar transmission signals from the first target object, to obtain the trajectory information of the first target object in each space.

11. The method of claim **9,** wherein the marking the entrance and exit positions of each space on the trajectory diagram for each space comprises:
in response to a spatial open and close event triggered in each space, respectively determining positions of the first target object in each space at the time when the spatial open and close event is triggered;
marking the entrance and exit positions of each space at corresponding regions on the trajectory diagram of each space based on determined positions.

12. The method of claim **9,** wherein the marking the entrance and exit positions of each space on the trajectory diagram for each space comprises:
in response to a marking operation on an access location, determining two adjacent spaces associated with the access location; wherein the access location is configured to indicate a position at which the second target object passes when entering or exiting between the two adjacent spaces;
marking the access location on trajectory diagrams of the two adjacent spaces as the entrance and exit positions for the two adjacent spaces.

13. A method for displaying an environmental model, performed by an electronic device, the method comprising:
displaying an environmental model corresponding to a target scene; the environmental model comprising at least one state of first target objects and of the second target objects in the target scene; wherein the environmental model is generated based on a spatial layout diagram of the target scene and positions of the second target objects in the target scene; wherein the spatial layout diagram is generated based on a relationship between a trajectory of each first target object in the target scene and each space in the target scene;
when a change in at least one state of the first target objects and the second target objects is recognized, displaying at least one of an updated first target object and of an updated second target object in the environmental model.

14. The method of claim **13,** wherein the method further comprises:
displaying at least one among the trajectory and a motion state of each first target object in the target scene in the environmental model; or
displaying at least one among a position, an object type, and an operating state of each second target object in the target scene in the environmental model.

15. The method of claim **13,** wherein states of the first target objects and the second target objects comprise at least one among an object type, an operating state, a position, a trajectory, and a motion state.

16. An apparatus for generating an environmental model, wherein the apparatus comprises:
a layout diagram display module, configured to display a spatial layout diagram corresponding to a target scene; wherein the spatial layout diagram is generated based on a relationship between a trajectory of a first target object in the target scene and each space in the target scene;
an object identification module, configured to identify second target objects deployed in the target scene and determine positions of second target objects in the target scene;
a model generation module, configured to generate the environmental model of the target scene, based on the positions of the second target objects in the target scene and the spatial layout diagram corresponding to the target scene; and wherein the environmental model is configured to describe at least one state of the first target object and of each second target object in the target scene.

17. An apparatus for displaying an environmental model, wherein the apparatus comprises:
a model display module configured to display an environmental model corresponding to a target scene; wherein the environmental model comprises at least one state of first target objects and second target objects in the target scene; wherein the environmental model is generated based on a spatial layout diagram of the target scene and positions of the second target objects in the target scene; and wherein the spatial layout diagram is generated based on a relationship between a trajectory of each first target object in the target scene and each space in the target scene;
a display update module configured to, when a change in at least one state of the first target objects and the second target objects is recognized, display at least one of an updated first target object and of an updated second target object in the environmental model.

18. An electronic device comprising at least one processor and at least one memory, wherein computer readable instructions are stored on the memory; which, when the computer readable instructions are performed by one or more processors, carry out the steps of the method based on any one of claims **1** to **10.**

19. A computer readable storage medium having computer readable instructions stored thereon, which, when performed by one or more processors, carry out the steps of the method based on any one of claims **1** to **10.**

20. A computer program product comprising computer readable instructions, which, when performed by a processor, carry out the steps of the method based on any one of claims **1** to **11.**
